# EUROPÄISCHE PATENTANMELDUNG

(11) **EP 3 428 004 A1**
(43) Veröffentlichungstag der Anmeldung: **16.01.2019**
(21) Anmeldenummer: 18182745.2
(22) Anmeldetag: 10.07.2018
(51) Int. Cl.: B60L 13/03, H02K 41/02, H02K 3/52, H02K 11/33, H01R 4/2425, H05K 3/32

(54) **MONTAGEVERFAHREN FÜR EINEN LANGSTATORLINEARMOTOR**

(30) Priorität: 12.07.2017 AT 505772017
(71) Anmelder: B&R Industrial Automation GmbH, 5142 Eggelsberg (AT)
(72) Erfinder: Reinthaler, Michael, 5223 Pfaffstätt (AT); Stojcic, Goran, 5102 Anthering (AT)
(74) Vertreter: Patentanwälte Pinter & Weiss OG

(57) **Zusammenfassung**

Um ein einfaches und schnelles Montageverfahren für die Montage zumindest einer Leistungselektronikeinheit (4) eines Transportsegments eines Langstatorlinearmotors am Transportsegment (1), mit möglichst geringer Belastung der Leistungselektronikeinheit (4) während der Montage, zu schaffen, ist erfindungsgemäß vorgesehen, dass am Transportsegment (1) zumindest eine Kontaktbuchse (8) zur Aufnahme zumindest eines Kontaktelements (3) der Antriebsspule (2) angeordnet wird, dass das zumindest eine Kontaktelement (3) der Antriebsspule (2) in der Kontaktbuchse (8) angeordnet wird, dass zumindest ein, mit der Kontaktbuchse (8) korrespondierendes, Klemmelement (9) mit einem Klemmabschnitt (10) in die Kontaktbuchse (8) eingeführt wird, wobei das Kontaktelement (3) der Antriebsspule (2), unter Herstellung einer elektrisch leitenden Verbindung mit dem Klemmabschnitt (10) des Klemmelements (9), vom Klemmelement (9) in der Kontaktbuchse (8) fixiert wird, und dass zumindest ein Kontaktpunkt (5) der zumindest einen Leistungselektronikeinheit (4), unter Herstellung einer elektrisch leitenden Verbindung, unmittelbar mit einem Verbindungsabschnitt (12) des Klemmelements (9) verbunden wird, wobei zuerst das Kontaktelement (3) der Antriebsspule (2) in der Kontaktbuchse (8) angeordnet wird, danach das Klemmelement (9) mit dem Klemmabschnitt (10) in die Kontaktbuchse (8) eingeführt wird und danach der Kontaktpunkt (5) der Leistungselektronikeinheit (4) unmittelbar durch Löten oder Stecken mit dem Verbindungsabschnitt (12) des Klemmelements (9) verbunden wird.

## Beschreibung

Die Erfindung betrifft ein Montageverfahren zur Anbindung zumindest einer Leistungselektronikeinheit an ein Transportsegment eines Langstatorlinearmotors, wobei das Transportsegment zumindest eine Antriebsspule mit zumindest zwei Kontaktelementen aufweist und die zumindest eine Leistungselektronikeinheit zumindest zwei, mit den Kontaktelementen der Antriebsspule korrespondierende, Kontaktpunkte aufweist, wobei eine elektrisch leitende Verbindung zwischen den Kontaktelementen der Antriebsspule und den Kontaktpunkten der zumindest einen Leistungselektronikeinheit hergestellt wird.

Bei einem hinlänglich bekannten Langstatorlinearmotor ist eine Vielzahl von elektrischen Antriebsspulen, die den Stator bilden, nebeneinander entlang einer Transportstrecke ortsfest angeordnet. Auf einer Transporteinheit ist eine Anzahl von Antriebsmagneten, entweder als Permanentmagnete oder als elektrische Spule oder Kurzschlusswicklung, angeordnet, die mit den Antriebsspulen zusammenwirken. Durch das Zusammenwirken der (elektro)magnetischen Felder der Antriebsmagnete und der Antriebsspulen wirkt eine Vortriebskraft auf die Transporteinheit, die die Transporteinheit vorwärtsbewegt. Der Langstatorlinearmotor kann als Synchronmaschine, sowohl selbsterregt oder fremderregt, oder als Asynchronmaschine ausgeführt sein. Durch Ansteuerung der einzelnen Antriebsspulen durch das Anlegen von Spulenspannungen zur Regelung des magnetischen Flusses, wird die Größe der Vortriebskraft beeinflusst und die Transporteinheit kann in gewünschter Weise entlang der Transportstrecke bewegt werden.

Oftmals ist der Langstator bzw. eine Transportstrecke auch in Form von einzelnen Streckenabschnitten aufgebaut, die wiederum aus zusammengefügten Transportsegmenten bestehen. Durch diese Modularität kann ein Langstatorlinearmotor einfacher aufgebaut werden, insbesondere wenn definierte Streckenabschnitte und Transportsegmente verwendet werden. Die konstruktive Ausgestaltung des Langstatorlinearmotors, also z.B. die Ausführung der Antriebsspulen, der Förderstrecke, der Transporteinheiten, der Führungen der Transporteinheit, usw., kann natürlich verschieden sein, wobei das grundlegende Funktionsprinzip eines Langstatorlinearmotors aber gleich bleibt.

Beispiele solcher Langstatorlinearmotoren können der WO 2013/143783 A1, der US 6,876,107 B2, der US 2013/0074724 A1 oder der WO 2004/103792 A1 entnommen werden.

Die Antriebsspulen sind üblicherweise durch eine sogenannte Nutteilung in Längsrichtung voneinander beabstandet an der Transportstrecke bzw. an einem Transportsegment angeordnet. Zur Erzeugung einer Vortriebskraft auf die Transporteinheit wird an die einzelnen Antriebsspulen in der Regel eine Spulenspannung angelegt, deren Parameter (z.B. Höhe und Dauer der Spannung) üblicherweise von einer Regelungseinheit entsprechend der gewünschten Bewegung der Transporteinheit (Position, Geschwindigkeit, Beschleunigung) laufend während des Betriebs der Transporteinrichtung festgelegt werden. Die Spannungsversorgung erfolgt dabei mittels einer Leistungselektronikeinheit, welche normalerweise in Form einer Platine an der Transportstrecke bzw. einem Transportsegment angeordnet ist. Die Leistungselektronikeinheit weist dabei in der Regel eine, der Zahl der Antriebsspulen des Transportsegments entsprechende, Zahl an Kontaktpunkten auf, sodass eine elektrisch leitende Verbindung zwischen den Antriebsspulen und der Leistungselektronikeinheit hergestellt werden kann. Durch die große Anzahl von Antriebsspulen, welche in einem relativ engen Abstand voneinander an einem Transportsegment angeordnet sind, sind natürlich auch an den Herstellungsprozess bzw. die Montage insbesondere eines Transportsegments hohe Anforderungen gestellt. Um die Produktion zu vereinfachen bzw. zu beschleunigen werden vorteilhafterweise alle Antriebsspulen gleichzeitig, d.h. in einem Arbeitsschritt, mit der Leistungselektrinikeinheit bzw. der Platine elektrisch leitend verbunden. Dazu werden die Drähte der einzelnen Antriebsspulen beispielsweise mit den korrespondierenden Kontaktpunkten der Platine kontaktiert und verlötet, was aber aufgrund des engen zur Verfügung stehenden Raumes eine sehr aufwändige Prozessführung erfordert, was nachteilig ist. Alternativ können z.B. auch Schraubklemmen an der Platine angeordnet sein, in welche die Drähte der Antriebsspulen eingeführt werden, worauf die Schrauben der Schraubklemmen festgezogen werden. Aufgrund der üblicherweise sehr großen Anzahl von Antriebsspulen und der engen Platzverhältnisse ist ein gleichzeitiges Festziehen aller Schraubverbindungen nicht oder nur unter sehr hohem Prozessaufwand möglich. Ein sequentielles Festziehen der Schraubverbindungen wäre zwar möglich, würde aber wiederum die Montagezeit verlängern, was nachteilig ist. Sowohl das Verschrauben, als auch das Verlöten der Drähte der Antriebsspulen an der Platine erfordert zudem ein vorheriges Abisolieren der, üblicherweise als Lackdrähte ausgeführten, Drähte der Antriebsspulen, was sehr aufwändig bzw. zeitintensiv und daher nachteilig ist.

Die WO 2016/008827 A2, EP 1 909 362 A1, DE 199 24 323 A1, DE 10 2012 106 471 A1 und EP 3 236 564 A1 zeigen rotative Elektromotoren in verschiedenen Ausgestaltungen mit Leiterplatten, welche mit Spulenwicklungen elektrisch verbunden sind. Bei einem Langstatorlinearmotor werden allerdings in der Regel wesentlich mehr Antriebsspulen mit einer Leiterplatte verbunden, als bei rotativen Elektromotoren. Im Stand der Technik ist demnach keine zufriedenstellende Lösung gezeigt, die gewährleistet, dass bei der Montage von Transportsegmenten eines Langstatorlinearmotors keine unzulässig hohen Kräfte auf die Leiterplatte wirken.

Demgemäß besteht die Aufgabe der Erfindung darin, ein einfaches und schnelles Montageverfahren für die Montage einer Leistungselektronikeinheit eines Transportsegments eines Langstatorlinearmotors am Transportsegment, mit möglichst geringer Belastung der Leistungselektronikeinheit während der Montage, zu schaffen.

Die Aufgabe wird erfindungsgemäß gelöst, indem am Transportsegment zumindest eine Kontaktbuchse zur Aufnahme zumindest eines Kontaktelements der Antriebsspule angeordnet wird, dass das zumindest eine Kontaktelement der Antriebsspule in der Kontaktbuchse angeordnet wird, dass zumindest ein, mit der Kontaktbuchse korrespondierendes, Klemmelement mit einem Klemmabschnitt in die Kontaktbuchse eingeführt wird, wobei das Kontaktelement der Antriebsspule, unter Herstellung einer elektrisch leitenden Verbindung mit dem Klemmabschnitt des Klemmelements, vom Klemmelement in der Kontaktbuchse fixiert wird, und dass zumindest ein Kontaktpunkt der Leistungselektronikeinheit, unter Herstellung einer elektrisch leitenden Verbindung, unmittelbar mit einem Verbindungsabschnitt des Klemmelements verbunden wird, wobei zuerst das Kontaktelement der Antriebsspule in der Kontaktbuchse angeordnet wird, danach das Klemmelement mit dem Klemmabschnitt in die Kontaktbuchse eingeführt wird und danach der Kontaktpunkt der Leistungselektronikeinheit durch Löten oder Stecken unmittelbar mit dem Verbindungsabschnitt des Klemmelements verbunden wird. Dadurch wird zuerst das Klemmelement mit einer zum Klemmen notwendigen Montagekraft beaufschlagt und erst danach die Leistungselektronikeinheit an das Klemmelement angebunden, wodurch die Leistungselektronikeinheit entlastet wird.

Vorteilhafterweise werden am Transportsegment aber zumindest zwei Kontaktbuchsen zur Aufnahme jeweils zumindest eines Kontaktelements angeordnet, wobei die zumindest zwei Kontaktelemente in den Kontaktbuchsen angeordnet werden, wobei zumindest zwei, mit den Kontaktbuchsen korrespondierende, Klemmelemente mit jeweils einem Klemmabschnitt sequentiell oder gleichzeitig in die Kontaktbuchsen eingeführt werden und wobei zumindest zwei Kontaktpunkte der zumindest einen Leistungselektronikeinheit sequentiell oder gleichzeitig mit den Verbindungsabschnitten der Klemmelemente verbunden werden. Dadurch ist es möglich eine (oder mehrere) Leistungselektronikeinheit(en) an mehrere, vorzugsweise alle Antriebsspulen eines Transportsegments anzubinden.

Vorteilhafterweise wird das zumindest eine Kontaktelement der Antriebsspule als elektrisch leitender Draht mit einer äußeren Isolierschicht, als sogenannter Lackdraht, ausgeführt und das zumindest eine Klemmelement wird als Schneidklemmelement mit einem Schneidklemmabschnitt ausgeführt, wobei beim Einführen des Schneidklemmelements in die zumindest eine Kontaktbuchse der Schneidklemmabschnitt die äußere Isolierschicht des Kontaktelements der Antriebsspule zur Herstellung der elektrisch leitenden Verbindung durchtrennt. Dadurch kann auch bei Verwendung eines isolierten Drahts ein einfaches Herstellen einer elektrisch leitenden Verbindung zwischen den Kontaktelementen und dem Klemmelement erreicht werden.

Bevorzugterweise wird der Verbindungsabschnitt des Klemmelements als Clip-Verbindungsabschnitt ausgeführt und der korrespondierende Kontaktpunkt der Leistungselektronikeinheit wird als Clip-Kontaktpunkt ausgeführt, wobei der Clip-Verbindungsabschnitt zur Verbindung der Leistungselektronikeinheit mit dem Klemmelement in den damit korrespondierenden Clip-Kontaktpunkt der Leistungselektronikeinheit unter Aufbringung einer Einpresskraft eingepresst wird. Dadurch wird die Montage vereinfacht und die Einpresskraft kann durch die Clip-Verbindungen gering gehalten werden.

Vorteilhafterweise wird der zumindest eine Kontaktpunkt der Leistungselektronikeinheit als eine, mit der Form des Verbindungsabschnitts des Klemmelements korrespondierende, die Leistungselektronikeinheit durchdringende Öffnung mit geschlossener Umfangsfläche ausgeführt wobei bei der Verbindung der Leistungselektronikeinheit mit dem Klemmelement, der Verbindungsabschnitt die Öffnung zumindest teilweise durchdringt und von der geschlossenen Umfangsfläche der Öffnung vollständig umschlossen wird.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 eine Explosionsdarstellung einer bevorzugten Ausführungsform der Erfindung,
Fig. 2 a und 2b Verfahrensabschnitte der Verwendung eines Schneidklemmelements und
Fig. 3 eine Detailansicht eines Schneidklemmelements.

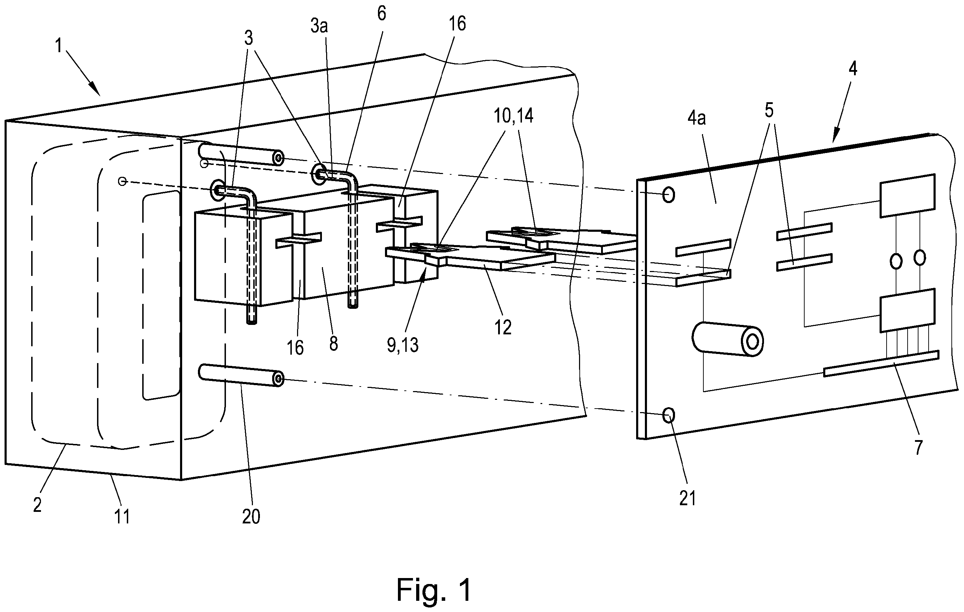

In Fig. 1 ist ein Transportsegment 1 eines Langstatorlinearmotors in einer Explosionsdarstellung gezeigt. Dabei sind am Transportsegment 1 bekanntermaßen eine Vielzahl von Antriebsspulen 2 in Längsrichtung mit einem bestimmten Abstand, der sogenannten Nutteilung, voneinander beabstandet angeordnet. Aus Gründen der Übersichtlichkeit ist in Fig. 1 aber nur eine Antriebsspule 2 angedeutet. Üblicherweise sind die Antriebsspulen 2 in einem geschlossenen Gehäuse 11 des Transportsegments 1 angeordnet, wobei das Gehäuse 11 oftmals auch mit einer Vergussmasse ausgegossen ist.

Die Antriebsspule 2 weist zum Anlegen einer Spannung üblicherweise zumindest zwei Kontaktelemente 3 auf, mittels denen eine elektrisch leitende Verbindung zu Kontaktpunkten 5 einer Leistungselektronikeinheit 4 hergestellt wird. Dazu sind die Kontaktelemente 3 gegebenenfalls aus dem Gehäuse 11 des Transportsegment 1 herausgeführt, um kontaktiert werden zu können. Die Kontaktelemente 3 der Antriebsspule 2 sind vorzugsweise in Form von elektrisch isolierten Drähten, besonders bevorzugt als Lackdrähte 3a, ausgeführt, die mit einer Isolierschicht 6 (z.B. aus Lack) ummantelt sind.

Die Leistungselektronikeinheit 4 ist vorzugsweise als herkömmliche Leiterplatine 4a ausgeführt, auf der Elektronikkomponenten 7 angeordnet sind (Elektronikkomponenten 7 sind für die Erfindung nicht wichtig und dienen in Fig. 1 nur der besseren Veranschaulichung).

Am Transportsegment 1 ist zumindest eine Kontaktbuchse 8 zur Aufnahme zumindest eines Kontaktelements 3 angeordnet, vorzugsweise ist die Kontaktbuchse 8, wie in Fig. 1 dargestellt, so ausgeführt, dass sie zur Aufnahme der beiden Kontaktelemente 3 einer Antriebsspule 2 geeignet ist. Es könnte aber auch je Kontaktelement 3 eine separate Kontaktbuchse 8 am Transportsegment 1 angeordnet sein, aufgrund der engen Platzverhältnisse ist es aber vorteilhaft, dass die Kontaktbuchse 8 zumindest die beiden Kontaktelemente 3 einer Antriebsspule 2 aufnehmen kann. Es wäre natürlich auch denkbar, eine Kontaktbuchse 8 so auszuführen, dass mehrere Kontaktelemente 3 benachbarter Antriebsspulen 2 aufgenommen werden können, wodurch die Anzahl einzelner Kontaktbuchsen 8 weiter reduziert werden könnte. Beispielsweise wäre es möglich nur eine Kontaktbuchse 8 in Form einer Leiste über die gesamte Länge des Transportsegments 1 anzuordnen, welche zur Aufnahme aller Kontaktelemente 3 aller Antriebsspulen 2 des Transportsegments geeignet ist. Die Kontaktbuchse 8 ist vorzugsweise aus einem elektrisch nichtleitenden Material wie beispielsweise Kunststoff ausgeführt.

Die Leistungselektronikeinheit 4 bzw. Leiterplatine 4a weist zumindest einen Kontaktpunkt 5, zur Herstellung einer elektrisch leitenden Verbindung mit der Antriebsspule 2, auf bzw. mit den Kontaktelementen 3 der Antriebsspule 2. Vorzugsweise entspricht die Zahl der Kontaktpunkte 5 der Platine 4a der Zahl der Kontaktelemente 3, d.h. dass z.B. je Antriebsspule 2 zwei Kontaktpunkte 5 an der Platine 4a angeordnet sein können. Im Falle von z.B. 80 Antriebsspulen 2 pro Transportsegment 1 wären demgemäß z.B. 160 Kontaktpunkte 5 an der Platine 4a angeordnet, die mit 160 Kontaktelementen 3 der Antriebsspulen 2 korrespondieren und verbunden werden müssen. Es muss aber nicht zwangsläufig eine einzige Leistungselektronikeinheit 4 bzw. Platine 4a am Transportsegment angeordnet werden, es könnte z.B. eine Platine 4a auch in mehrere Platinensegmente unterteilt sein, welche jeweils eine bestimmte Zahl von Kontaktpunkten 5 zur Verbindung mit entsprechenden Kontaktelementen 3 der Antriebsspulen 2 aufweisen.

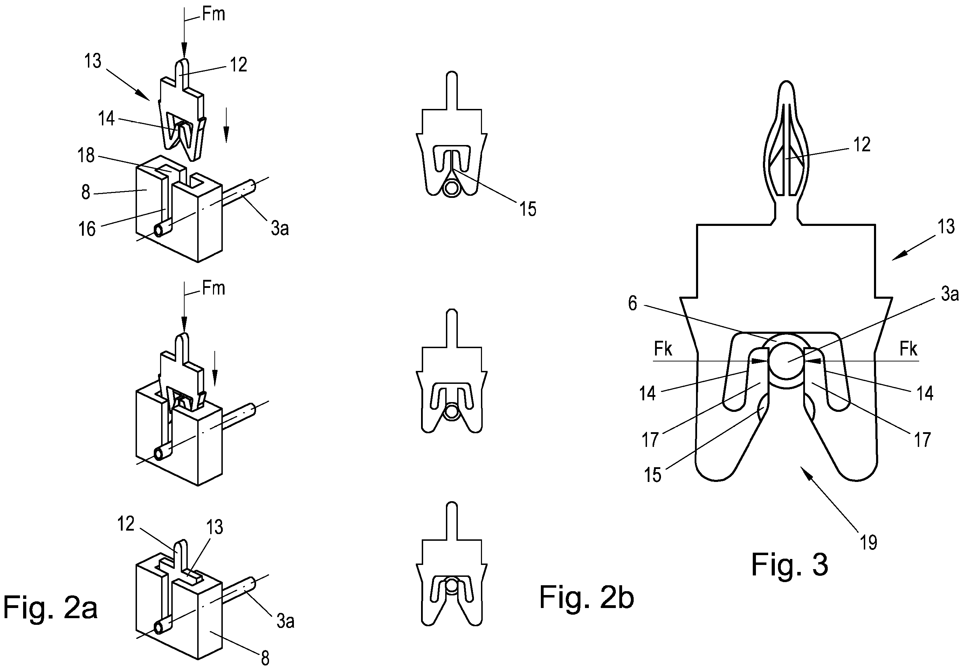

Erfindungsgemäß wird am Transportsegment 1 zumindest ein, mit der Kontaktbuchse 8 korrespondierendes, Klemmelement 9 angeordnet, das mit einem Klemmabschnitt 10 so in die Kontaktbuchse 8 eingeführt wird, dass das Kontaktelement 3 der Antriebsspule 2, unter Herstellung einer elektrisch leitenden Verbindung, mit dem Klemmabschnitt 10 des Klemmelements 9, vom Klemmelement 9 in der Kontaktbuchse 8 fixiert wird, wie nachfolgend mit Bezugnahme auf die Fig.2 noch näher erläutert wird.

Im Ausführungsbeispiel der Fig.1 sind die Kontaktelemente 3 aus dem Gehäuse 11 herausgeführt und um ungefähr 90° umgebogen, sodass die freien Enden der Kontaktelemente 3 in Aufnahmenuten 16 der am Gehäuse 11 angeordneten Kontaktbuchse 8 angeordnet sind.

Nachdem das Klemmelement 9 in der Kontaktbuchse 8 fixiert wurde, wird zumindest ein Kontaktpunkt 5 der Leistungselektronikeinheit 4, unter Herstellung einer elektrisch leitenden Verbindung, mit einem Verbindungsabschnitt 12 des Klemmelements 9 verbunden. Vorzugsweise wird aber je Kontaktelement 3 einer Antriebsspule 2 ein Klemmelement 9 angeordnet. Das hat den Vorteil, dass die auf die Klemmelemente 9 aufzubringende Kraft, die zum Verklemmen der Kontaktelemente 3 in den Kontaktbuchsen 8 erforderlich ist, z.B. von einem geeigneten Montagewerkzeug aufgenommen werden kann. Die Leistungselektronikeinheit 4 kann danach mit den Kontaktpunkten 5 an die bereits fixierten Klemmelemente 9 ohne bzw. mit wenig Kraftaufwand angeordnet werden.

Es kann aber auch zuerst der Kontaktpunkt 5 der Leistungselektronikeinheit 4, unter Herstellung einer elektrisch leitenden Verbindung, mit dem Verbindungsabschnitt 12 des Klemmelements 9 verbunden werden und erst danach das Klemmelement 9 unter Kontaktierung des Kontaktelementes 3 in der Kontaktbuchse 8 fixiert werden. Dieses Verfahren kann insbesondere bei Transportsegmenten 1 mit weniger Antriebsspulen 2 angewandt werden. Wenn die Leistungselektronikeinheit 4 geeignet ist, die zum Verklemmen der Kontaktelemente 3 in den Kontaktbuchsen 8 erforderlichen Kräfte aufzunehmen, wäre es daher auch denkbar, die Klemmelemente 9, sequentiell oder in einem Arbeitsschritt, an die Leistungselektronikeinheit 4 anzubinden und die gesamte Leistungselektronikeinheit 4 inklusive der daran angeordneten Klemmelemente 9 gleichzeitig in die Kontaktbuchsen 8 mit darin angeordneten Kontaktelementen 3 der Antriebsspulen 2 einzuführen und alle Kontaktelementen 3 gleichzeitig zu verklemmen.

Das Einführen der Klemmelemente 9 in die einzelnen Kontaktbuchsen 8 kann sequentiell, also in zeitlich nacheinander ausgeführten ersten Arbeitsschritten der Montage oder gleichzeitig, in einem einzigen ersten Arbeitsschritten der Montage erfolgen. Die Verbindung der Kontaktpunkte 5 der Leistungselektronikeinheit 4 mit den Verbindungsabschnitten 12 der (bereits an den Kontaktbuchsen 8 geklemmten) Klemmelemente 9 kann danach wiederum sequentiell, also in zeitlich nacheinander ausgeführten zweiten Arbeitsschritten der Montage erfolgen oder gleichzeitig in einem einzigen zweiten Arbeitsschritt erfolgen.

Es wäre aber auch denkbar, dass zuerst die Verbindung der Kontaktpunkte 5 der Leistungselektronikeinheit 4 mit den Verbindungsabschnitten 12 der Klemmelemente 9 sequentiell, also in zeitlich nacheinander ausgeführten ersten Arbeitsschritten der Montage erfolgt oder gleichzeitig, in einem einzigen ersten Arbeitsschritten der Montage. Das Einführen der, bereits an der Leistungselektronikeinheit 4 angebundenen Klemmelemente 9 in die Kontaktbuchsen 8 könnte dann in einem einzigen zweiten, nachfolgenden, Arbeitsschritt der Montage erfolgen.

Gemäß der dargestellten bevorzugten Ausführungsform der Erfindung sind die Kontaktelemente 3 mit einer äußeren Isolierschicht 6 ausgeführt und die Klemmelemente 9 sind als Schneidklemmelemente 13 ausgeführt, wie in Fig.2 im Detail dargestellt. Die Schneidklemmelemente 13 weisen dabei natürlich wiederum jeweils einen, als Schneidklemmabschnitt 14 ausgeführten, Klemmabschnitt 10 und einen Verbindungsabschnitt 12 auf. Wenn die Schneidklemmelemente 13 mit den Schneidklemmabschnitten 14 in die Kontaktbuchsen 8 eingeführt werden, wird die Isolierschicht 6 des jeweiligen Lackdrahts 3a von, am Schneidklemmabschnitt 14 angeordneten Schneiden 15 durchtrennt, sodass ein elektrisch leitender Kontakt zwischen dem Schneidklemmabschnitt 14 des Schneidklemmelements 13 und dem Kontaktelement 3hergestellt wird. Gleichzeitig wird dadurch das Kontaktelement 3 auch geklemmt und fixiert, sodass eine sichere elektrische Kontaktierung gewährleistet ist. Der Schneidklemmabschnitt 14 ist dabei natürlich elektrisch leitend mit dem Verbindungsabschnitt 12 verbunden.

Die einzelnen Schritte des Einführens des Schneidklemmelements 13 in die Kontaktbuchse 8 sind in den Fig. 2a und 2b im Detail dargestellt, Fig. 3 zeigt ein Schneidklemmelement 13 im Detail. Zuerst wird das mit einer Isolationsschicht 6 isolierte Kontaktelement 3 in die Kontaktbuchse 8 eingelegt, was rein maschinell und automatisiert erfolgen kann. Die Kontaktbuchse 8 weist dabei eine geeignete Öffnung zur Aufnahme des Kontaktelementes 3auf, z.B. eine längliche Aufnahmenut 16 wie in Fig. 2a ersichtlich ist. Beispielsweise können die Kontaktelemente 3 zur Durchführung des erfindungsgemäßen Montageverfahrens in einem ersten Arbeitsschritt, vor dem Einführen der Schneidklemmelemente 13 in die Kontaktbuchsen 8, in geeigneter Weise gebogen werden, um in den Aufnahmenuten 16 der Kontaktbuchsen 8 angeordnet werden zu können. In Fig. 1 sind die Kontaktelemente 3beispielsweise in einem Winkel von 90° gebogen, je nach Ausführungsform der Kontaktbuchsen 8 sowie der Klemmelemente 9 sind natürlich auch andere Anordnungen denkbar.

Wie in Fig. 3 dargestellt, weist das Schneidklemmelement 13 der bevorzugten Ausführungsform am Schneidklemmabschnitt 14 zwei einander zugewandte Klemmteile 17 mit jeweils einer Schneide 15 zum Durchtrennen der Isolierschicht 6 des Lackdrahts 3a auf, zwischen welchen eine Führungsöffnung 19 zur Führung des Lackdrahts 3a angeordnet ist.

Das Schneidklemmelement 13 wird, wie durch den Pfeil in Fig.2a angedeutet, in eine Kontaktöffnung 18 der Kontaktbuchse 8 so eingeführt, dass das, bereits in der Aufnahmenut 16 der Kontaktbuchse 8 angeordnete, Kontaktelement 3 von der Führungsöffnung 19 aufgenommen wird (siehe Fig. 2b oben). Beim weiteren Einführen des Schneidklemmelements 13 (siehe Fig. 2a, 2b Mitte) in die Kontaktöffnung 18 erfolgt das Durchtrennen der Isolierschicht 6 des Lackdrahts 3a mittels der, an den Klemmteilen 17 angeordneten, Schneiden 15. Dabei wird die Isolierschicht 6 des Lackdrahts 3a so durchtrennet, dass eine elektrisch leitende Verbindung zwischen dem leitenden Kern des Kontaktelement 3, also z.B. der Litze des Lackdrahts 3a, und dem Schneidklemmelement 13 hergestellt wird. Durch das weitere Einführen des Schneidklemmelements 13 bis zum Ende der Kontaktöffnung 18, das vorzugsweise gleichzeitig als physischer Anschlag für das Schneidklemmelement 13 dient, werden die Klemmteile 17 des Schneidklemmabschnitts 14 vorzugsweise elastisch verformt, wodurch eine beidseitige Klemmkraft Fₖ auf das Kontaktelement 3 ausgeübt wird (siehe Fig. 3). Dadurch kann eine Fixierung des Kontaktelementes 3 am Schneidklemmelement 13 und dadurch eine elektrisch leitende Verbindung zwischen Kontaktelement 3 und Schneidklemmelement 13 gewährleistet werden. Um ein Lösen des Schneidklemmelements 13 aus der Kontaktbuchse 8 und eine damit verbundene Unterbrechung des elektrischen Kontakts zu vermeiden, könnte beispielsweise zusätzlich ein Sicherungselement (nicht dargestellt) an der Kontaktbuchse 8 oder am Transportsegment 1 vorgesehen werden. Es wäre z.B. denkbar, dass das Schneidklemmelement 13 bei Erreichen der Endposition, also des Anschlags, der Kontaktbuchse 8 in ein geeignetes Sicherungselement einrastet oder in anderer geeigneter Weise gegen ein Lösen gesichert wird.

Um das Schneidklemmelement 13 gegen die Klemmkraft Fₖ in die Kontaktbuchse 8 einführen zu können, ist natürlich eine Montagekraft Fₘ in Längsrichtung des Schneidklemmelements 13 erforderlich, wie in Fig. 2a dargestellt. Je nach Material und konstruktiver Ausgestaltung des Schneidklemmelements 13 variiert auch die erforderliche Montagekraft Fₘ. Üblicherweise ist aber nicht nur eine Antriebsspule 2 mit zwei Kontaktelementen 3 an einem Transportsegment 1 angeordnet, sondern eine Vielzahl von Antriebsspulen 2 mit jeweils zwei Kontaktelementen 3. Demgemäß ist dann vorzugsweise eine, der Zahl der Kontaktelemente 3 entsprechende, Zahl von Schneidklemmelementen 13 zur Verbindung der Kontaktpunkte 5 der Leistungselektronikeinheit 4 bzw. Leiterplatine 4a mit den Kontaktelementen 3 der Antriebsspulen 2 vorgesehen. Beim erfindungsgemäßen Montageverfahren können, wie bereits beschrieben wurde, alle Schneidklemmelemente 13 gleichzeitig in einem Arbeitsschritt der Montage in die Kontaktöffnungen 18 der entsprechenden Kontaktbuchsen 8 eingeführt werden. Dadurch ergibt sich in Summe natürlich eine wesentlich größere erforderliche Montagekraft Fₘ, als bei dem Klemmen nur eines Schneidklemmelements 13. Die erforderliche Gesamt-Montagekraft ergibt sich aus der Summe der gleichzeitig in die Kontaktbuchsen 8 eingeführten Schneidklemmelemente 13 zu F_{mG} = ∑Fₘᵢ (der Index i steht dabei für die Zahl der Schneidklemmelemente 13).

Üblicherweise ist eine Leiterplatine 4a aus einem nicht leitenden und relativ spröden Kunststoff gefertigt und ist deshalb nur begrenzt in der Lage, Kräfte aufzunehmen, was bei der Durchführung des Montageverfahrens berücksichtigt werden sollte. Würden die Schneidklemmelemente 13 beispielsweise zuerst an der Platine 4a angeordnet werden und erst dann gemeinsam in einem Arbeitsschritt in die Kontaktbuchsen 8 eingeführt werden, sollte die Platine 4a also geeignet sein, die zum Klemmen aller angeordneten Schneidklemmelemente 13 erforderliche Gesamt-Montagekraft F_{mG} aufzunehmen.

Ist die Platine 4a zur Aufnahme der Gesamt-Montagekraft F_{mG} nicht geeignet, ist es vorteilhaft, wenn zuerst die Schneidklemmelemente 13, gleichzeitig (oder sequentiell), in einem ersten Arbeitsschritt in die Kontaktbuchsen 8 unter Aufbringung der Gesamt-Montagekraft F_{mG} (bzw. der einzelnen Montagekräfte Fₘᵢ) eingeführt werden. Dabei werden die Isolierschichten 6 aller Kontaktelemente 3 aller am Transportsegment 1 angeordneten Antriebsspulen 2 gleichzeitig durchtrennt und die Kontaktelemente 3, wie bereits ausführlich beschrieben, in den Kontaktbuchsen 8 unter Herstellung einer elektrisch leitenden Verbindung und durch die entstehenden Klemmkräfte Fₖ geklemmt. Vorzugsweise wird dieser erste Arbeitsschritt (bzw. die ersten Arbeitsschritte) mittels einer geeigneten Montagevorrichtung durchgeführt, die aber nicht Gegenstand der Erfindung ist und deshalb nicht näher darauf eingegangen wird.

Nachdem die Schneidklemmelemente 13 in den Kontaktbuchsen 8 ordnungsgemäß angeordnet sind, kann in einem nächsten Arbeitsschritt, die Platine 4a mit dem Transportsegment 1 verbunden werden. Dazu werden die Kontaktpunkte 5 der Platine 4a, vorzugsweise wiederum gleichzeitig (oder sequentiell), mit den bereits in den Kontaktbuchsen 8 des Transportsegments 1 geklemmten Schneidklemmelementen 13 mittels einer geeigneten Montagevorrichtung verbunden. Montagevorrichtungen sind im Stand der Technik bekannt und die konkrete Ausgestaltung der Montagevorrichtung ist nicht relevant und nicht Teil der Erfindung. Vorteilhafterweise ist dazu der Verbindungsabschnitt 12 des Klemmelements 9 bzw. des Schneidklemmelements 13 als Clip-Verbindungsabschnitt oder als Lötverbindungsabschnitt ausgeführt und der korrespondierende Kontaktpunkt 5 der Platine 4a ist als Clip-Kontaktpunkt oder Lötkontaktpunkt ausgeführt. In Fig. 3 ist beispielsweise der Verbindungsabschnitt 12 des Klemmelements 9 bzw. des Schneidklemmelements 13 als Clip-Verbindungsabschnitt ausgeführt. Zur Anbindung des Klemmelements 9 an die Platine 4a wird der Clip-Verbindungsabschnitt in den damit korrespondierenden Clip-Kontaktpunkt der Platine 4a unter Aufbringung einer Einpresskraft eingepresst. Dadurch wird ohne zu Löten eine elektrisch leitende Verbindung zwischen dem Clip-Kontaktpunkt der Platine 4a und dem Kontaktelement 9 hergestellt. Es wären auch andere Ausführungsformen denkbar, wichtig ist hierbei, dass möglichst wenig Kraft für die Verbindung der Platine 4a mit den Verbindungsabschnitten 12 der Klemmelemente 9 bzw. Schneidklemmelemente 13 aufgewendet werden muss, um die Platine 4a nicht zu beschädigen. Clip-Verbindungen haben den Vorteil, dass eine lötfreie und folglich sehr rasche Montage der Klemmelemente 9 an der Platine 4a möglich ist, allerdings sind zur Herstellung der Clip-Verbindung Einpresskräfte zu berücksichtigen. Eine Lötverbindung ist zwar im Vergleich zu einer Clip-Verbindung etwas aufwändiger, hat allerdings den Vorteil, dass keine Einpresskräfte auftreten, wodurch keine mechanische Belastung auf die Leistungselektronikeinheit 4 bzw. Platine 4a auftritt. In Fig. 2 a ist beispielsweise der Verbindungsabschnitt 12 des Klemmelements 9 bzw. des Schneidklemmelements 13 als Lötverbindungsabschnitt bzw. als sogenannte Lötfahne ausgeführt. Zur Herstellung einer elektrisch leitenden Verbindung zwischen Klemmelement 9 und der Platine 4a wird der Lötverbindungsabschnitt mit einem geeigneten korrespondierenden LötKontaktpunkt der Platine 4a kontaktiert und verlötet.

Vorteilhafterweise werden am Transportsegment 1 Befestigungselemente 20 zur Befestigung der Platine 4a am Transportsegment 1 angeordnet und an der Platine 4a damit zusammenwirkende Befestigungspunkte 21. Befestigungselemente 20 können beispielsweise herkömmliche Schraubverbindungen sein. Dadurch kann die, insbesondere durch das Gewicht der Platine 4a, hervorgerufene Belastung besser vom Transportsegment 1 aufgenommen werden und die Klemmelemente 9 können entlastet werden.

## Patentansprüche

1. Montageverfahren zur Anbindung zumindest einer Leistungselektronikeinheit (4) an ein Transportsegment (1) eines Langstatorlinearmotors, wobei das Transportsegment (1) zumindest eine Antriebsspule (2) mit zumindest zwei Kontaktelementen (3) aufweist und die zumindest eine Leistungselektronikeinheit (4) zumindest zwei, mit den Kontaktelementen (3) der Antriebsspule (2) korrespondierende, Kontaktpunkte (5) aufweist, wobei eine elektrisch leitende Verbindung zwischen den Kontaktelementen (3) der Antriebsspule (2) und den Kontaktpunkten (5) der zumindest einen Leistungselektronikeinheit (4) hergestellt wird, **dadurch gekennzeichnet, dass** am Transportsegment (1) zumindest eine Kontaktbuchse (8) zur Aufnahme zumindest eines Kontaktelements (3) der Antriebsspule (2) angeordnet wird, **dass** das zumindest eine Kontaktelement (3) der Antriebsspule (2) in der Kontaktbuchse (8) angeordnet wird, **dass** zumindest ein, mit der Kontaktbuchse (8) korrespondierendes, Klemmelement (9) mit einem Klemmabschnitt (10) in die Kontaktbuchse (8) eingeführt wird, wobei das Kontaktelement (3) der Antriebsspule (2), unter Herstellung einer elektrisch leitenden Verbindung mit dem Klemmabschnitt (10) des Klemmelements (9), vom Klemmelement (9) in der Kontaktbuchse (8) fixiert wird, **und dass** zumindest ein Kontaktpunkt (5) der zumindest einen Leistungselektronikeinheit (4), unter Herstellung einer elektrisch leitenden Verbindung, unmittelbar mit einem Verbindungsabschnitt (12) des Klemmelements (9) verbunden wird, wobei zuerst das Kontaktelement (3) der Antriebsspule (2) in der Kontaktbuchse (8) angeordnet wird, danach das Klemmelement (9) mit dem Klemmabschnitt (10) in die Kontaktbuchse (8) eingeführt wird und danach der Kontaktpunkt (5) der Leistungselektronikeinheit (4) durch Löten oder Stecken mit dem Verbindungsabschnitt (12) des Klemmelements (9) verbunden wird.

2. Montageverfahren nach Anspruch 1, **dadurch gekennzeichnet,** am Transportsegment (1) zumindest zwei Kontaktbuchsen (8) zur Aufnahme jeweils zumindest eines Kontaktelements (3) angeordnet werden, **dass** die zumindest zwei Kontaktelemente (3) in den Kontaktbuchsen (8) angeordnet werden, **dass** zumindest zwei, mit den Kontaktbuchsen (8) korrespondierende, Klemmelemente (9) mit jeweils einem Klemmabschnitt (10) sequentiell oder gleichzeitig in die Kontaktbuchsen (8) eingeführt werden **und dass** zumindest zwei Kontaktpunkte (5) der zumindest einen Leistungselektronikeinheit (4) sequentiell oder gleichzeitig mit den Verbindungsabschnitten (12) der Klemmelemente (9) verbunden werden.

3. Montageverfahren nach Anspruch 1 oder 2, **dadurch gekennzeichnet, dass** das zumindest eine Kontaktelement (3) der Antriebsspule (2) als elektrisch leitender Draht mit einer äußeren Isolierschicht (6), als sogenannter Lackdraht (3a), ausgeführt wird **und dass** das zumindest eine Klemmelement (9) als Schneidklemmelement (13) mit einem Schneidklemmabschnitt (14) ausgeführt wird, wobei beim Einführen des Schneidklemmelements (13) in die zumindest eine Kontaktbuchse (8) der Schneidklemmabschnitt (14) die äußere Isolierschicht (6) des Kontaktelementes (3) der Antriebsspule (2) zur Herstellung der elektrisch leitenden Verbindung durchtrennt.

4. Montageverfahren nach einem der Ansprüche 1 bis 3, **dadurch gekennzeichnet, dass** der Verbindungsabschnitt (12) des Klemmelements (9) als Clip-Verbindungsabschnitt ausgeführt wird und der korrespondierende Kontaktpunkt (5) der Leistungselektronikeinheit (4) als Clip-Kontaktpunkt ausgeführt wird, wobei der Clip-Verbindungsabschnitt zur Verbindung der Leistungselektronikeinheit (4) mit dem Klemmelement (9) in den damit korrespondierenden Clip-Kontaktpunkt der Leistungselektronikeinheit 4 unter Aufbringung einer Einpresskraft eingepresst wird.

5. Montageverfahren nach einem der Ansprüche 1 bis 4, **dadurch gekennzeichnet, dass** der zumindest eine Kontaktpunkt (5) der Leistungselektronikeinheit (4) als eine, mit der Form des Verbindungsabschnitts (12) des Klemmelements (9) korrespondierende, die Leistungselektronikeinheit (4) durchdringende Öffnung mit geschlossener Umfangsfläche ausgeführt wird und dass bei der Verbindung der Leistungselektronikeinheit (4) mit dem Klemmelement (9), der Verbindungsabschnitt (12) die Öffnung zumindest teilweise durchdringt und von der geschlossenen Umfangsfläche der Öffnung vollständig umschlossen wird.
